# EUROPÄISCHE PATENTSCHRIFT

(11) **EP 0 287 107 B1**
(45) Veröffentlichungstag und Bekanntmachung des Hinweises auf die Patenterteilung: **23.08.1995**
(21) Anmeldenummer: 88106007.3
(22) Anmeldetag: 15.04.1988
(51) Int. Cl.: H01H 35/02, H03K 17/975

(54) **Lageschalter zum Schalten von elektrischen Aggregaten**
Position switch for switching electrical aggregates
Interrupteur de position pour la commutation d'agrégats électriques

(30) Priorität: 16.04.1987 DE 3712974; 18.05.1987 DE 3716263
(43) Veröffentlichungstag der Anmeldung: 19.10.1988
(73) Patentinhaber: Pepperl + Fuchs Füllstandstechnik Gmbh, D-6800 Mannheim (DE)
(72) Erfinder: Sütterlin, Rudolf, D-6832 Hockenheim (DE); Schmidt, Hans, D-6755 Hochspeyer (DE)
(74) Vertreter: Mierswa, Klaus, Dipl.-Ing.

(56) Entgegenhaltungen:
- BE-A- 843 942
- FR-A- 1 389 776
- FR-A- 2 339 947
- FR-A- 2 510 900
- US-A- 3 269 685

## Beschreibung

Die Erfindung geht aus von einem Lageschalter gemäß dem Oberbegriff des Anspruchs 1.

Durch die DE-PS 1 540 333 ist ein Schwimmschalter zum Schalten von Pumpen bekanntgeworden, der in einem an einem Kabel angeordneten Gehäuse einen elektrischen Schalter mit mechanischem Schaltorgan besitzt, auf das ein Schaltgewicht zur Schwerpunktsverlagerung des Lageschalters zum einen oder anderen Gehäuseende hin einwirkt, wobei entsprechend den verschiedenen Lagen, insbesondere verschiedenen Flüsigkeitshöhen, der Lageschalter um einen in einer Kabelaufhängung gegebenen Schwerpunkt geschwenkt und somit das Aggregat geschaltet werden kann. Das Schaltgewicht kann ein Gleitkörper oder eine Kugel sein, welches auf ein in die Schaltgewichts-Bewegungsbahn hineinragendes mechanisches Schaltorgan, wie Schalthebel oder Schaltstift, eines Elektroschalters einwirkt. Durch das deutsche Patent 28 43 484 ist ein im Prinzip ähnlicher Lageschalter bekanntgeworden, bei dem das Schaltgewicht ein Pendel ist, wobei durch die Pendelverlagerung des Pendels ein elektrischer Schalter betätigt werden kann.

Durch die BE-A-843 942 ist ein Lageschalter zum Schalten von elektrischen Aggregaten bekannt geworden, der aus zwei sich gegenüberstehenden, zueinander geneigten Gehäusen aus elektrisch nicht leitendem Material in Form je eines länglichen, hermetisch geschlossenen Kolbens besteht, innerhalb desselben je eine Kugel als Schaltgewicht frei beweglich zwischen den beiden Endlagen angeordnet ist, die die beiden Enden des Kolbens bilden. Im Bereich der einen Endlage außerhalb eines jeden Kolbens ist je eine elektrische Schaltstrecke angeordnet, in der die einfallende Kugel eine elektrische Änderung zu bewirken imstande ist. Durch die US-A-3269 685 ist eine auf einer Bahn rollenden Kugel mit einer Lichtschranke als Schaltstrecke bekannt geworden, die aus einer auf der einen Seite der Bahn angeordneten Lichtquelle und gegenüberliegend aus einer Photozelle besteht, die beim Durchlauf des Lichtstrahls durch die Kugel ein elektrisches Signal abzugeben imstande ist.

Des weiteren sind eine Vielzahl von sehr verschieden ausgestalteten Schaltern bekannt, die aus einem Glaskolben oder Glasballon bestehen, in welchem Quecksilber frei beweglich angeordnet ist, wobei in die Glaswandung zwei elektrische Kontakte eingeschmolzen sind, die bei Verlagerung des Quecksilbers in die Endstellung im Bereich der Kontakte miteinander verbunden werden und somit einen Stromkreis schließen.

Der Nachteil der vorgenannten Schwimmschalter besteht darin, daß diese nur als Schwimmer, nicht jedoch universell z.B. für Schüttgüter, eingesetzt werden können. Des weiteren sind derartige Schwimmschalter nur zur Bewältigung einer relativ geringen Niveaudifferenz geeignet.

Die Schalter, die im Innern eines Glaskolbens Quecksilber beinhalten, stellen durchweg eine nicht zu unterschätzende Umweltgefahr dar, weil bei Zerstörung des Schalters das Quecksilber in die Umgebung austreten kann. Quecksilber und verschiedene Quecksilberverbindungen sind bekanntermaßen für den Menschen höchst giftig.

Der Erfindung liegt die Aufgabe zugrunde, einen Lageschalter der eingangs genannten Gattung zu schaffen, der zum einen universell als Lageschalter, beispielsweise als Schwimmschalter, als auch für sonstige bewegte Güter, zum Beispiel für Schüttgüter, eingesetzt werden kann, der zum anderen aber insbesondere Quecksilberschalter mit ihrem gefährlichen Inhalt ersetzen soll.

Die Lösung dieser Aufgabe besteht erfindungsgemäß in den Merkmalen des Anspruchs 1. Weitere Ausgestaltungen der Erfindung sind in den Unteransprüchen gekennzeichnet.

Der erfindungsgemäße Lageschalter besteht prinzipiell aus einem Kolben, der vorzugsweise ein Glaskolben ist oder aus einem anderen geeigneten Material, insbesondere Kunststoff, besteht, mit einer darin frei beweglichen Kugel zwischen zwei Endlagen, die vorzugsweise die Enden des Kolbens sind und einer elektrischen oder magnetischen Schaltstrecke im direkten Bereich einer der beiden Endlagen der Kugel, und durch die Verlagerung der Kugel in den Bereich der Schaltstrecke die Kugel eine elektromagnetische Änderung der Schaltstrecke bewirkt und diese ein elektrisches Signal abzugeben imstande ist, wobei die elektrische Schaltstrecke Drahtwindungen sind, die auf das eine Ende des Kolbens gewickelt sind, und die Windungen entweder eine elektrische Spule bilden oder die Drahtwindungen aus mindestens zwei separaten biphilaren Windungen bestehen und einen Kondensator bilden, oder daß zur Bildung eines Kondensators statt der Drahtwindungen derselbe aus zwei Platten besteht, die beidseitig an einem Ende des Kolbens angeordnet sind.

Der erfindungsgemäße Lageschalter besitzt den Vorteil, daß dieser praktisch beliebig sowohl als Schwimmschalter als auch als sonstiger Lageschalter einsetzbar ist. Der Lageschalter ersetzt vorteilhaft Quecksilberschalter, so daß er dem notwendigen gestiegenen Umweltbewußtsein und den heutigen strengeren Reinhaltebestimmungen der Umwelt Rechnung trägt, weil er kein Quecksilber enthält. Das ist ein entscheidener Vorteil gegenüber jedem Quecksilberschalter, der immer eine potentielle Gefahr für seine Umgebung darstellt.

Der erfindungsgemäße Lageschalter kann sowohl für die direkte Schaltung von 220 Volt-Stromkreisen, als auch für die Schaltung von Niedervolt-Stromkreisen ausgelegt sein. Des weiteren kann der Lageschalter nach den NAMUR-Richtlinien ausgelegt sein. Bei Verwendung von NAMUR-Relais mit eigensi-cheren (Ex i)-Stromkreisen kann der Einsatz in Schwimmschaltern in explosionsgefährdeten Bereichen der Zone 1 eingesetzt werden. Ein weiterer Vorteil des erfindungsgemäßen Lageschalters ist dadurch gegeben, daß eine Vielzahl von existierenden Schaltern mit Quecksilber durch den Lageschalter in bestehenden Anlagen ausgetauscht werden können, so daß derartige Anlagen umweltfreundlicher gemacht werden können.

Beispiele der Erfindung sind in der Zeichnung dargestellt und anschließend beschrieben. Dabei zeigen:
- Figur 1: eine Draufsicht auf eine Aufnahmehülse zur Aufnahme eines Glaskolbens gemäß Figur 2, wobei auf ein Ende der Aufnahmehülse eine elektrische Spule aufgewickelt ist,
- Figur 2: eine Ansicht eines Glaskolbens mit einer darin frei beweglichen Kugel als Schaltgewicht,
- Figur 3: einen Teilschnitt durch die Aufnahmehülse der Figur 1,
- Figur 4: eine Draufsicht auf die Bohrung der Aufnahmehülse
- Figur 5: einen weiteren Glaskolben mit einer darin frei beweglichen Kugel als Schaltgewicht,
- Figur 6: ein weiteres Beispiel eines Glaskolbens mit darin freibeweglicher Kugel, wobei auf ein Ende des Glaskolbens zwei sich gegenüberliegende metallisierte Flächen als Kondensator aufgebracht sind
- Figur 7a: ein Prinzip-Schaltbild mit einem Schwingkreis aus L1 und C1, in welchem die Spule 10 auf der Aufnahmehülse der Figur 1 als Induktivität einbezogen ist und
- Figur 7b: einen Prinzip-Schaltkreis mit einem Schwingkreis aus L2-C2, in dem der Kondensator 10′ in Form einer bifilar gewickelten Spule auf der Aufnahmehülse der Figur 1 als Kapazität einbezogen ist.

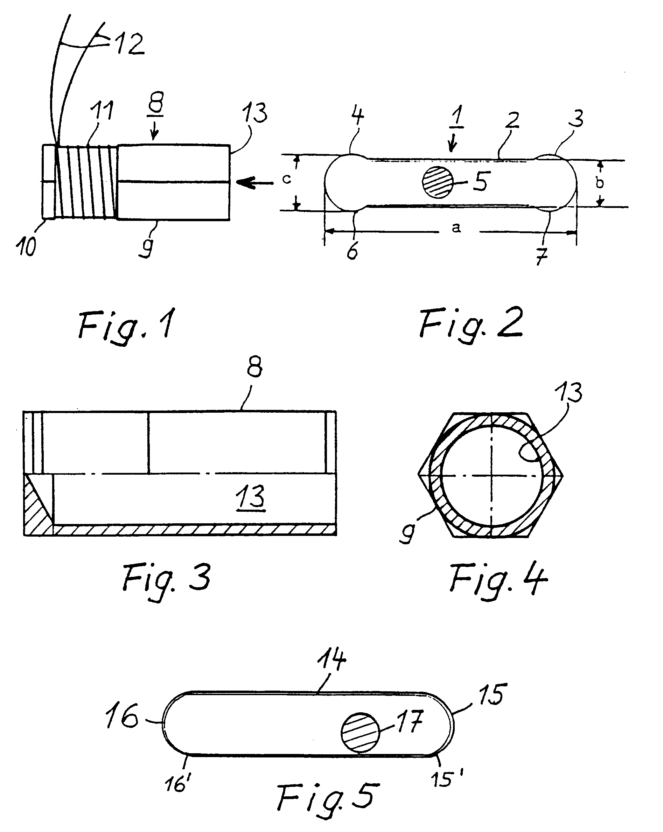

Der Lageschalter oder Sensor der Figuren 1 bis 4 besteht aus einem Glaskolben 1, der gewöhnlich länglich mit einem zylindrischen Mittelteil 2 ausgestaltet ist, an welches sich zwei Endteile 3,4 anschließen. Der Glaskolben 1 ist hermetisch verschlossen. Innerhalb des Glaskolbens 1 ist eine Kugel 5 frei beweglich angeordnet, die aus elektrisch leitendem Material, wie Metall, oder aus elektrisch nichtleitendem Material, wie Kunststoff, bestehen kann.

Die Enden 3,4 des Glaskolbens 1 können verdickt sein und Ausbuchtungen 6,7 aufweisen, die ringförmig umlaufen. Die Ausbuchtungen 6,7 stellen die beiden Endlagen der Bewegungsbahn der Kugel 5 dar. Gleichzeitig bilden diese Ausbuchtungen Verzögerungen für den Beginn der Bewegung der Kugel, da diese erst nach einer bestimmten Neigung des Glaskolbens 1 aus der Ausbuchtung herausrollen kann. Damit kann durch verschiedene Ausgestaltungen der Ausbuchtung, an beiden oder nur an einem Ende des Glaskolbens, die Verzögerung der Kugel in weiten Grenzen beeinflußt bzw. die Neigung des Kolbens vorgegeben werden, bei welcher ein Schaltvorgang ausgelöst wird. Bei unterschiedlicher Ausgestaltung der beiden Enden sind die Neigungen, bei denen die Schaltvorgänge ausgelöst werden, in vorteilhafter Weise verschieden.

Im unmittelbaren Bereich der einen Endlage der Kugel und somit im Bereich des einen Endes des Glaskolbens, die Schaltlage, ist eine elektromagnetische Schaltstrecke angeordnet, die im einfachsten Fall aus einer Spule besteht, die mit ihren Windungen über die Entstellung des Glaskolbens gewickelt ist. Im gezeigten Beispiel ist eine Spule 10 mit ihren Windungen 11 auf das Ende einer Aufnahmehülse 8 gewickelt, die zentrisch längs ihrer Mittelachse eine Bohrung 13 aufweist, die vorzugsweise eine Sackbohrung ist. In diese Bohrung 13 ist der Glaskolben 1 eingesteckt, was in den Figuren 1 und 2 durch den Richtungspfeil gekennzeichnet ist. Bei eingestecktem Glaskolben 1 innerhalb der Aufnahmehülse 8 befindet sich die Ausbuchtung 6 im Bereich bzw. inner-halb der Spule 10 und bildet somit die schaltende Endlage des Lageschalters. Mit der Bezugsziffer 12 sind die elektrischen Anschlüsse der Spule 10 gekenn-zeichnet. Die Aufnahmehülse kann als Sechskant 9 geformt sein.

Die Spule 10 ist hier Teil eines Schwingkreises, bestehtend aus L1 und C1, wobei bei Verwendung einer metallischen Kugel die Induktivität des Schwingkreises durch Änderung der Induktivität L1 verändert und der Schwingkreis verstimmt oder in Resonanz gebracht werden kann. Auf diese Weise kann bei Verlagerung der Kugel in die schaltende Endlage durch Verstimmung des Schwingkreises L1-C1 ein elektrisches Signal als Schaltsignal diskriminiert werden, welches geeignet in bekannter Weise verstärkt werden kann.

Figur 1 beinhaltet des weiteren eine Ausführung des Sensors mittels einer Kapazität. Der Kondensator besteht aus der Spule 10′, die aus mindestens zwei separaten, biphilaren Windungen 11′ besteht, die auf das Ende der Aufnahmehülse 8 gewickelt sind, in die der Kolben 1 gesteckt ist. In diesem Falle wird somit die Kapazität der mindestens zwei separaten, biphilaren Windungen 11′ als elektrisch veränderbare Größe herangezogen. Dieser Kondensator 10′, der gleichzeitig die Induktivität L2 haben kann, kann gemäß Figur 7b Teil eines Schwingkreises sein, wodurch insbesondere bei Verwendung einer metallischen Kugel die Kapazität C2 des Kondensators 10′ verändert und der Schwingkreis verstimmt oder in Resonanz gebracht werden kann.

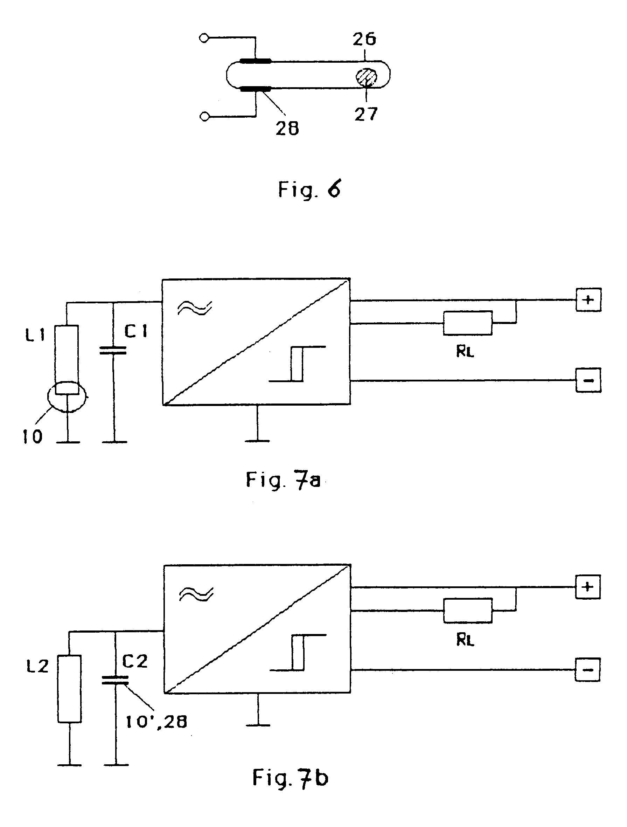

Figur 5 zeigt ein weiteres Beispiel eines Kolbens 14, der als einfacher länglicher zylindrischer Kolben gestaltet ist mit abgerundeten Enden 15,16. Innerhalb des Kolbens 14 befindet sich eine Kugel 17, die elektrisch leitend oder nichtleitend sein kann. Diese Form des Kolbens 14 besitzt dementsprechend keine Verzögerung für die Kugel 17, die jeder Lageänderung des Kolbens 14 praktisch synchron folgen kann, wobei die Endlagen 15′, 16′ der Kugel praktisch mit den Enden 15,16 des Kolbens zusammenfallen. Der Kolben kann ein Glaskolben sein oder aus einem sonstigen geeigneten Material bestehen.

Figur 6 zeigt ein weiteres Beispiel eines Glaskolbens 26, der gemäß dem Glaskolben der Figur 5 gestaltet ist und in dem sich freibeweglich eine Kugel 27, vorzugsweise aus Metall, befindet. Auf das eine Ende des Glaskolbens 26 sind zwei metallische Flächen aufgebracht, die zusammen einen Kondensator 28 bilden, der Teil eines Schwingkreises gemäß Figur 7b oder einer nicht gezeigten Brückenschaltung sein kann. Bewegt sich die Kugel 27 in den Bereich der metallischen Flächen des Kondensators 28, so wird dessen Kapazität geändert, wodurch ein Schwingkreis verstimmt werden kann.

Figur 7a zeigt ein schematisches elektrisches Schaltbild mit einem elektrischen Schwingkreis, bestehend aus der Kapazität C1 und der Induktivität L1, in die die Induktivität der Spule 10 einbezogen ist. Läuft die Kugel 5 in Figur 2 in den Bereich der Spule 10 ein, so wird der Schwingkreis L1, C1 verstimmt, wodurch am Eingang eines integrierten Schaltkreises ein Signal aus dem Schwingkreis ansteht, welches durch den Schaltkreis geeignet verstärkt und weiterverarbeitet werden kann.

Figur 7b zeigt ein schematisches elektrisches Schaltbild mit einem elektrischen Schwingkreis, bestehend aus der Induktivität L2 und der Kapazität C2, in welche die Kapazität des Kondensators 10′ bzw. 28 einbezogen ist.

Läuft die Kugel 5 bzw. 27 der Figuren 2 bzw. 6 in den Bereich der Kapazität 10′ bzw. 28 ein, so wird der Schwingkreis L2, C2 wiederum verstimmt; das entstehende Signal kann geeignet verstärkt und weiterverarbeitet werden.

### Liste der Bezugszeichen:

- 1: Glaskolben
- 2: Mittelteil des Glaskolbens
- 3,4: Endteile des Glaskolbens
- 5: Kugel
- 6,7: Ausbuchtungen der Endteile des Glaskolbens
- 8: Aufnahmehülse
- 9: Sechskant
- 10: Spule
- 10′: Kapazität
- 11, 11′: Windungen
- 12: Anschlüsse der Spule
- 13: Bohrung
- 14: Glaskolben
- 15,16: Enden des Glaskolbens
- 15′, 16′: Endlagen der Kugel
- 17: Kugel
- 18: Glaskolben
- 26: Glaskolben
- 27: Kugel
- 28: Kondensator
- L1-C1, L2-C2: elektrische Schwingkreise

## Patentansprüche

1. Lageschalter zum Schalten von elektrischen Aggregaten, wie Schwimmschalter zum Schalten von Pumpen, bestehend aus einem Gehäuse aus einem elektrisch nicht leitenden Material in Form eines länglichen, hermetisch geschlossenen Kolbens (2,14,26), innerhalb desselben eine Kugel (5,17,27) als Schaltgewicht frei beweglich zwischen den beiden Endlagen (6,7;15,16′) angeordnet ist, die die beiden Enden (3,4;15,16) des Kolbens bilden, wobei im unmittelbaren Bereich der einen Endlage (6,16′) außerhalb des Kolbens eine elektrische Schaltstrecke (10;10′,11,28) angeordnet ist, zwischen der sich die Endlage (6,16′) befindet und innerhalb der die einfallende Kugel eine elektrische Änderung zu bewirken imstande ist,
dadurch gekennzeichnet,
daß die elektrische Schaltstrecke Drahtwindungen (11) sind, die auf das eine Ende des Kolbens (1,14,26) gewickelt sind, wobei die Windungen (11) entweder eine elektrische Spule (10) bilden oder die Drahtwindungen aus mindestens zwei separaten biphilaren Windungen (11′) bestehen und einen Kondensator (10′,28) bilden oder daß zur Bildung eines Kondensators (28) statt der Drahtwindungen derselbe aus zwei Platten besteht, die beidseitig an einem Ende des Kolbens (26) angeordnet sind.

2. Lageschalter nach Anspruch 1, dadurch gekennzeichnet,
daß die Drahtwindungen (11) sowohl für die elektrische Spule (10) als auch für den Kondensator (10′,28) auf das Ende eine Aufnahmehülse (8) aufgewickelt sind, in die der Kolben (1,14) gesteckt ist.

3. Lageschalter nach Anspruch 1 oder 2, dadurch gekennzeichnet,
daß die elektrische Schaltstrecke Teil einer Brückenschaltung ist.

4. Lageschalter nach Anspruch 1 oder 2, dadurch gekennzeichnet,
daß die Spule (10) oder der Kondensator (10′,28) Teil eines elektrischen Schwingkreises (L1-C1,L2-C2) sind.

5. Lageschalter nach Anspruch 1 oder 2, dadurch gekennzeichnet,
daß die elektrische Schaltstrecke sowohl eine Spule (10,11) als auch einen Kondensator (10′,28) aufweist.

6. Lageschalter nach Anspruch 1, dadurch gekennzeichnet,
daß der Kolben (1) ein Glaskolben ist und an mindestens einem Ende (3,4) eine Ausbuchtung (6,7) zum Einfallen der Kugel (5) aufweist.

7. Lageschalter nach Anspruch 1 oder 3, dadurchgekennzeichnet,
daß der Kondensator (28) Teil einer Brückenschaltung ist.

## Claims

1. Position switch to switch electrical aggregates such as floating switches to switch pumps, consisting of a housing made of an electrically non-conductive material in the form of an elongated, hermetically sealed piston (2, 14, 26) within which a sphere (5, 17, 27) is arranged as a switching weight in such a way that it can move freely between the two final positions (6, 7; 15, 16′) which constitute the two ends (3, 4; 15, 16) of the piston whereby, in the immediate vicinity of one final position (6, 16′) outside of the piston, there is an electric contact-break distance (10, 10′; 11, 28) between which the final position (6, 16′) is located and, within said distance, the falling sphere is capable of bringing about an electrical change,
characterized in that
the electrical contact-break distance consists of wire windings (11) which are wound onto one end of the piston (1, 14, 26), whereby the windings (11) either form an electric coil (10) or else the wire windings consist of at least two separate bipolar windings (11′) and form a condenser (10′, 28) or in that, in order to form a condenser (28), instead of the wire windings, said condenser consists of two plates, both sides of which are arranged at one end of the piston (26).

2. Position switch according to Claim 1, characterized in that
the wire windings (11) for the electric coil (10) as well as for the condenser (10′, 28) are wound up on the end of a receiving sleeve (8) into which the piston (1, 14) is inserted.

3. Position switch according to Claim 1 or 2, characterized in that
the electric contact-break distance is part of a bridge circuit.

4. Position switch according to Claim 1 or 2, characterized in that
the coil (10) or the condenser (10′, 28) is part of an electrical resonating circuit (L1-C1, L2-C2).

5. Position switch according to Claim 1 or 2, characterized in that
the electric contact-break distance has a coil (10, 11) as well as a condenser (10′, 28).

6. Position switch according to Claim 1, characterized in that
the piston (1) is a glass piston and has a bulge (6, 7) into which the sphere (5) falls.

7. Position switch according to Claim 1 or 3, characterized in that
the condenser (28) is part of a bridge circuit.

## Revendications

1. Interrupteur de position destiné à la manoeuvre sur des groupes électriques, tels que des interrupteurs à flotteurs pour la manoeuvre sur des pompes, comportant un boîtier en un matériau non conducteur sous forme d'un piston oblong hermétiquement fermé (2,14,26), dans lequel une sphère mobile (5,17,27) qui sert de poids de commutation est disposée entre les deux positions finales (6,7;15,16′) formées par les deux extrémités (3,4;15,16) du piston, une section de commutation électrique (10;10′,11,28) étant disposée à l'extérieur du piston à proximité immédiate de l'une des positions finales (6,16′) et entre laquelle se trouve la position finale (6,16′) et dans laquelle la sphère qui entre peut avoir pour effet une modification électrique,
caractérisé en ce que
la section de commutation électrique est constituée par des spires de fil (11) enroulées sur l'une des extrémités du piston (1,14,26), lesdites spires (11) formant ou bien une bobine électrique (10) ou bien encore consistant en au moins deux spires bifilaires séparées (11′) qui forment un condensateur (10′,28), ou bien que, pour former un condensateur (28), celui-ci, au lieu des spires de fil, consiste en deux plaques disposées des deux côtés d'une extrémité du piston (26).

2. Interrupteur de position suivant la revendication 1, caractérisé en ce que les spires de fil (11) pour la bobine électrique (10) tout comme pour le condensateur (10′,28) sont enroulées sur l'extrémité d'une douille réceptrice (8) dans laquelle est introduit le piston (1,14).

3. Interrupteur de position suivant l'une quelconque des revendications 1 ou 2, caractérisé en ce que la section de commutation électrique fait partie d'un circuit en pont.

4. Interrupteur de position suivant l'une quelconque des revendications 1 ou 2, caractérisé en ce que la bobine (10) ou le condensateur (10′,28) font partie d'un circuit électrique oscillant (L1-C1,L2-C2).

5. Interrupteur de position suivant l'une quelconque des revendications 1 ou 2, caractérisé en ce que le parcours de commutation électrique présente non seulement une bobine (10,11), mais aussi un condensateur (10′,28).

6. Interrupteur de position suivant la revendication 1, caractérisé en ce que le piston (1) est un piston en verre dont au moins l'une des extrémités (3,4) est dotée d'une partie courbée pour l'entrée de la sphère (5).

7. Interrupteur de position suivant les revendications 1 ou 3, caractérisé en ce que le condensateur (28) fait partie d'un circuit en pont.
